# FASCICULE DE BREVET EUROPEEN

(11) **EP 0 418 775 B1**
(45) Date de publication et mention de la délivrance du brevet: **01.03.1995**
(21) Numéro de dépôt: 90117837.6
(22) Date de dépôt: 17.09.1990
(51) Int. Cl.: H03C 5/00, H01F 27/28

(54) **Circuit de modulation en phase et en amplitude**
Amplituden- und Phasenmodulator
Phase and amplitude modulation circuit

(30) Priorité: 20.09.1989 FR 8912335
(43) Date de publication de la demande: 27.03.1991
(73) Titulaire: ALCATEL MOBILE COMMUNICATION FRANCE, 75008 Paris (FR)
(72) Inventeur: Habian, Albert, F-75009 Paris (FR)
(74) Mandataire: Weinmiller, Jürgen

(56) Documents cités:
- EP-A- 0 324 240
- EP-A- 0 371 157
- GB-A- 2 084 809
- CONFERENCE PROCEEDINGS OF THE 7TH EUROPEAN MICROWAVE CONFERENCE, Copenhagen, 5-8 septembre 1977, pages 601-605, Sevenoaks, Kent, GB; B.R. HALLFORD: "2dB conversion loss mixer at 11 GHz using a PRM circuit"

## Description

La présente invention concerne un circuit de modulation en phase et en amplitude.

Les circuits de modulation utilisés en radiofréquence et particulièrement dans le domaine de fréquence proches de 900 MHz comprennent généralement des mélangeurs et des circuits de répartition. Tant les circuits de répartition qui permettent d'obtenir deux signaux symétriques à partir d'un signal d'entrée ou, au contraire, de produire un signal résultant à partir de deux signaux d'entrée, que les mélangeurs, sont souvent constitués autour d'un transformateur bobiné sur ferrite.

Les performances de tels circuits de modulation, particulièrement l'affaiblissement des raies parasites, dépendent de l'équilibrage en phase et en amplitude des mélangeurs et des circuits de répartition. L'affaiblissement de la porteuse, notamment, est directement lié, à la valeur de l'isolation entre le signal de l'oscillateur local et le signal radiofréquence des mélangeurs. L'équilibrage en phase et en amplitude des modules du circuit de répartition dépend en grande partie de la symétrie des transformateurs utilisés qui comportent un point milieu. Or, il est très difficile de réaliser des transformateurs bobinés sur ferrite dans le domaine de fréquences, considéré dont le point milieu définisse une symétrie parfaite. De plus, ces transformateurs sont des éléments encombrants qui s'opposent à une miniaturisation du circuit de modulation.

La présente invention a ainsi pour objet un circuit de modulation qui présente une grande immunité aux raies parasites. Ce circuit de modulation, d'autre part, occupe un volume réduit.

Le circuit de modulation selon l'invention comprend un premier circuit de répartition recevant le signal local, deux mélangeurs, un circuit déphaseur et un deuxième circuit de répartition produisant le signal de sortie, ces circuits de répartition et ces mélangeurs incorporant chacun un transformateur, et se caractérise en ce que ces transformateurs sont réalisés par impression ou par gravure sur l'une ou l'autre des faces d'un même support.

Par ailleurs, dans le circuit de modulation, les points milieux des transformateurs des mélangeurs reçoivent une tension continue d'une valeur équivalente à celle qui est présente dans les signaux de modulation.

Les différents objets et caractéristiques de la présente invention ressortiront avec plus de précision dans la description d'exemples de réalisation donnés à titre non limitatif en se référant aux figures qui représentent:
- la figure 1, le diagramme d'un circuit de modulation d'un type connu,
- la figure 2, le schéma d'un circuit de répartition d'un type connu,
- la figure 3, le schéma d'un mélangeur d'un type connu,
- la figure 4, un transformateur d'un circuit de répartition du circuit de modulation selon l'invention,
- la figure 5, un transformateur d'un mélangeur du circuit de modulation selon l'invention,
- la figure 6, le schéma du circuit de modulation selon l'invention.

Les éléments présents dans différentes figures porteront une seule référence.

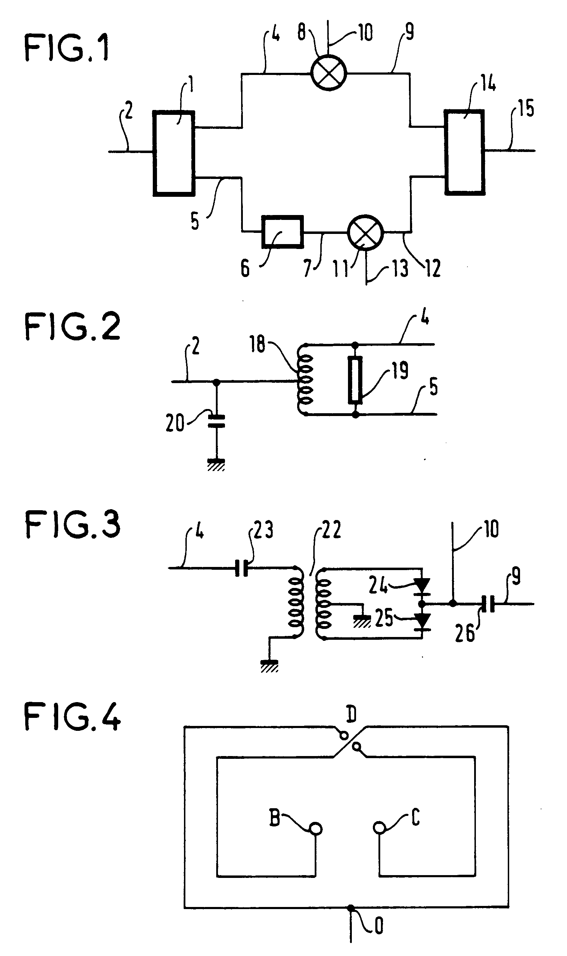

Afin de bien comprendre l'invention, la constitution d'un circuit de modulation sera rappelée en se reportant à la figure 1.

Ce circuit de modulation comprend un premier circuit de répartition 1 qui reçoit un signal local 2 issu d'un oscillateur local et le répartit de manière symétrique en deux signaux intermédiaires 4 et 5. Le signal intermédiaire 5 est traité par un circuit déphaseur 6 qui produit un signal déphasé 7. La valeur de ce déphasage est couramment de 90°. Il comprend également un premier mélangeur 8 qui produit un premier signal modulé 9 à partir du signal intermédiaire 4 et d'un premier signal de modulation 10 et un deuxième mélangeur 11 qui produit un deuxième signal modulé 12 à partir du signal déphasé 7 et d'un deuxième signal de modulation 13. Les deux signaux de modulation 10, 13 sont déphasés de 90°. Il comprend enfin un deuxième circuit de répartition 14 qui produit le signal de sortie par mixage des deux signaux modulés 9, 12.

Un circuit de répartition dont le schéma électrique est représenté dans la figure 2 comprend un transformateur à point milieu 18, une résistance 19 connectée aux bornes extrêmes de ce transformateur et un condensateur 20 relié au point milieu d'une part et à la masse d'autre part. Les références portés sur la figure correspondent au premier circuit de répartition 1, à savoir le signal local 2 est appliqué sur le point milieu, les signaux intermédiaires 4, 5 sont recueillis chacun sur une borne extrême du transformateur. Le deuxième circuit de répartition a une structure identique.

Un mélangeur, le premier cité 8 par exemple, dont le schéma électrique est représenté dans la figure 3 comprend un transformateur 22 à deux enroulements. Le signal intermédiaire 4 est appliqué par l'intermédiaire d'un condensateur 23 sur une extremité de l'enroulement primaire de ce transformateur 22, la deuxième extrémité de cet enroulement étant raccordée à la masse. L'enroulement secondaire pourvu d'un point milieu raccordé à la masse, est connecté sur deux diodes 24, 25 en série. Le signal de modulation 10 est injecté au point commun à ces deux diodes et le signal modulé 9 est recueilli de ce point commun par l'intermédiaire d'un condensateur 26.

Le circuit déphaseur 6 consistera, par exemple, en une longueur de ligne équivalente à un quart de la longueur d'onde du signal local 2 de manière à produire un déphasage de 90°.

A la suite de ce rappel du fonctionnement électrique d'un circuit de modulation, la réalisation sera maintenant décrite.

Le circuit de modulation est réalisé sur un support tel qu'un circuit imprimé double face éventuellement multicouches, ou sur un substrat céramique selon les technologies "couches épaisses" ou "couches minces". Tous les transformateurs sont réalisés par impression ou par gravure suivant l'une des technologies sus-mentionnée. Ils sont conformes, à la description faite dans la demande de brevet français 8903607.

A titre d'exemple, le transformateur imprimé à point milieu décrit ci-après en relation avec la figure 4 est un transformateur à deux spires OB et OC, chaque demi-enroulement se réduisant alors à une spire.

Ce transformateur correspond à un mode de réalisation optimal dans lequel le flux créé par chaque spire est identique au flux créé par l'autre, les spires OB et OC ayant même périmètre et embrassant la même surface, le schéma étant en effet entièrement symétrique par rapport à un axe vertical passant d'une part par le point milieu O et d'autre part par le point de croisement des spires, référencé D.
Dans ce mode de réalisation optimal, les deux demi-enroulements ont des selfs de fuite identiques.

Le point de croisement des spires peut être réalisé à l'aide de trous métallisés ; la présence d'une métallisation en regard du transformateur n'altère pas ses performances.

Le point de croisement des spires pourrait aussi être réalisé à l'aide d'un boîtier "chip" monté en surface de résistance nulle.

Les performances peuvent être encore optimisées en réduisant l'espace entre spires (par exemple de l'ordre de 15/100 de mm).

Une réduction de la largeur de la ligne imprimée (par exemple à 15/100 mm) permet par ailleurs de réduire les dimensions du transformateur.

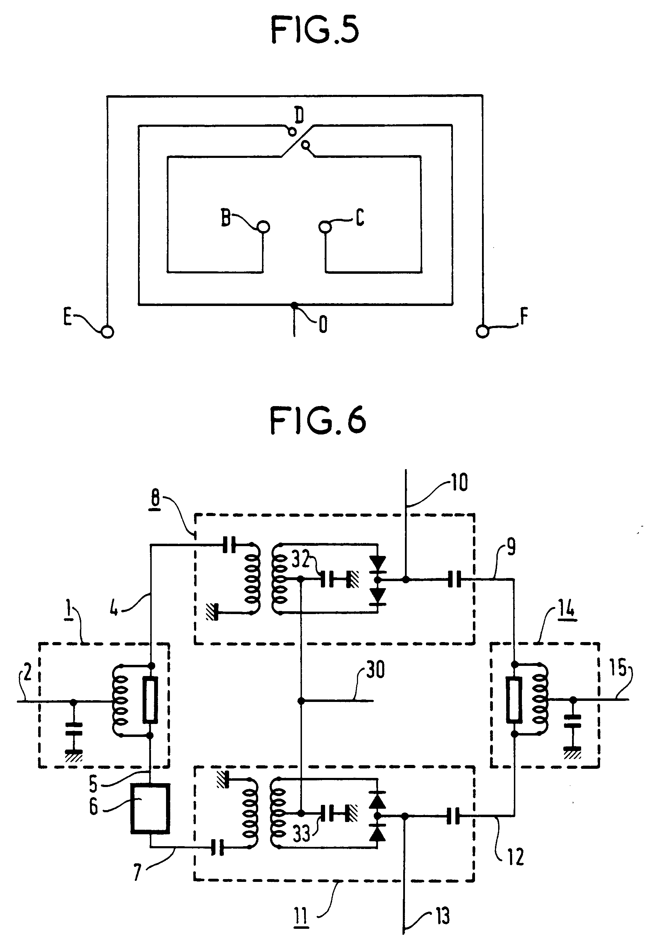

Ce type de transformateur sera employé dans les circuits de répartition 1, 14.
Un transformateur utilisé dans les mélangeurs 8,11 est représenté dans la figure 5. Il se déduit du précédent par l'adjonction d'une spire supplémentaire EF à la périphérie des précédentes, cette spire EF constituant l'enroulement primaire.

Lorsque le support du circuit de modulation comprend une couche interne d'isolation, il est alors possible de disposer des transformateurs sur chaque face sans se préoccuper d'éventuelles interactions.

Le circuit de modulation selon l'invention représenté dans la figure 6 permet de s'affranchir d'une composante continue présente dans les signaux de modulation 10, 13. En effet si ces signaux sont issus d'un circuit utilisant un amplificateur opérationnel par exemple, une tension continue superposée au signal utile est indésirable vis-à-vis des deux diodes du mélangeur. On peut la supprimer en utilisant un condensateur d'isolement mais si les fréquences employées dans le signal de modulation sont relativement basses la capacité de ce condensateur devra être importante et, par conséquent, ce composant sera volumineux. La solution retenue consiste à appliquer une tension continue 30 sur les points milieux des transformateurs des mélangeurs de même valeur que celle qui est présente dans les signaux de modulation. Les condensateurs 32, 33 isolent l'alimentation produisant cette tension continue vis-à-vis des signaux radiofréquence.

L'ensemble des éléments nécessaires à la réalisation comlète du circuit de modulation tels que les résistances ou les condensateurs seront des composants du type "composant monté en surface" ou seront réalisés directement par sérigraphie ou tout autre procédé déjà mentionné.

Ce circuit de modulation sera avantageusement utilisé en circuit de démodulation. En se référant à la figure 1, on injecte le signal à démoduler à la place du signal de sortie 15, les signaux démodulés étant reçus en sortie des mélangeurs à la place des signaux de modulation 10, 13.

L'invention trouvera application notamment en radiotéléphonie dans les postes mobiles où les signaux de modulation en bande de base, en phase 10 et en quadrature 13, seront appliqués sur les mélangeurs 8, 11.

## Revendications

1. Circuit de modulation comprenant un premier circuit de répartition (1) recevant le signal local (2), deux mélangeurs (8,11), un circuit déphaseur (6), un deuxième circuit de répartion (14) produisant le signal de sortie (15), ces circuits de répartition et ces mélangeurs incorporant chacun un transformateur, caractérisé en ce que lesdits transformateurs sont réalisés par impression ou par gravure sur l'une ou l'autre des faces d'un même support et en ce que les points milieux des tranformateurs des mélangeurs ( 8, 11) reçoivent une tension continue (30) d'une valeur équivalente à celle qui est présente dans les signaux de modulation (10, 13).

## Patentansprüche

1. Modulationsschaltung, die eine das örtliche Signal (2) empfangende erste Verteilschaltung, zwei Mischstufen (8, 11), einen Phasenschieber (6) und eine zweite Verteilschaltung (14) aufweist, die das Ausgangssignal (15) erzeugt, wobei die Verteilschaltungen und die Mischstufen je einen Transformator enthalten, dadurch gekennzeichnet, daß diese Transformatoren durch die Druckschaltungstechnik oder durch selektives Ätzen der einen oder anderen Seite eines gemeinsamen Trägers erhalten werden und daß die Mittelabgriffe der Transformatoren der Mischstufe (8, 11) eine Gleichspannung (30) eines Werts zugeführt erhalten, der der Gleichspannungskomponente in den Modulationssignalen (10, 13) äquivalent ist.

## Claims

1. Modulator circuit comprising a first splitter circuit (1) receiving the local signal (2), two mixers (8, 11), a phase-shifter circuit (6), a second splitter circuit (14) producing the output signal (15), these splitter circuits and these mixers incorporating a transformer, characterised in that said transformers are printed or etched on one or the other side of a common support and in that the centre taps of the transformers of the mixers (8, 11) receive a direct current voltage (30) whose value is equivalent to that present in the modulation signals (10, 13).
